# EUROPÄISCHE PATENTSCHRIFT

(11) **EP 0 583 298 B1**
(45) Veröffentlichungstag und Bekanntmachung des Hinweises auf die Patenterteilung: **27.12.1996**
(21) Anmeldenummer: 92909435.7
(22) Anmeldetag: 05.05.1992
(51) Int. Cl.: H03K 19/173, H03K 19/096, H03K 19/00

(54) **LOGIKSCHALTUNG FÜR ASYNCHRONE SCHALTUNGEN MIT N-KANAL-LOGIKBLOCK UND DAZU INVERSEM P-KANAL-LOGIKBLOCK**
LOGIC CIRCUIT FOR ASYNCHRONOUS CIRCUITS WITH n-CHANNEL LOGIC BLOCK AND p-CHANNEL LOGIC BLOCK INVERSE THERETO
CIRCUIT LOGIQUE POUR CIRCUITS ASYNCHRONES AVEC UN BLOC LOGIQUE A CANAL N ET UN BLOC LOGIQUE A CANAL P INVERSE DU PREMIER

(30) Priorität: 08.05.1991 DE 4115081
(43) Veröffentlichungstag der Anmeldung: 23.02.1994
(73) Patentinhaber: SIEMENS AKTIENGESELLSCHAFT, 80333 München (DE)
(72) Erfinder: KNAUER, Karl, D-8013 Grafing (DE)
(86) Internationale Anmeldenummer: DE9200366
(87) Internationale Veröffentlichungsnummer: WO9220156

(56) Entgegenhaltungen:
- EP-A- 0 147 598

## Beschreibung

Die Erfindung betrifft eine Logikschaltung nach dem Oberbegriff des Patentanspruchs 1.

Eine Logikschaltung dieser Art ist beispielsweise in der Veröffentlichung von T. Meng et al. mit dem Thema "Design of Clock-Free Asynchronous Systems for Real-Time Signal Processing" im Digest of Technical Papers Seite 2532 bis 2535 zur Konferenz IEEE ICCAD 89 wiedergegeben. Dabei handelt es sich um eine Logikschaltung mit zwei Logikblöcken, die jeweils aus n-Kanal-Transistoren gebildet sind und bei der jeweils ein Ausgang eines Logikblocks über einen Inverter mit dem Gate eines mit diesem Logikblock verbundenen Vorladetransistors rückgekoppelt ist, um jeweils die Ausgangsspannung der Logikblöcke solange statisch abzusichern, bis gültige Daten eine Potentialanderung am Ausgang der Logikschaltung bewirken.

Ferner ist aus der europaischen Patentanmeldung mit der Veröffentlichungsnummer 0 147 598 A1 ein System mit differentieller Kaskode-Spannungs-Schaltlogik bekannt, bei dem ein erster Logikblock und ein zweiter Logikblock jeweils aus einem Schalter besteht, wobei der Schalter des ersten Logikblocks immer dann geschlossen ist, wenn der Schalter des zweiten Logikblocks geöffnet ist und umgekehrt und wobei der Schalter des zweiten Logikblocks zum Schalter des ersten Logikblocks komplmentär angesteuert wird.

Der Erfindung liegt die Aufgabe zugrunde, eine Logikschaltung für asynchrone Schaltungen anzugeben, die eine größere Störsicherheit und eine geringere Verlustleistung unter gleichzeitiger Verwendung von konventionellen CMOS-Logikblöcken bietet.

Diese Aufgabe wird erfindungsgemäß durch die im kennzeichnenden Teil des Patentanspruchs 1 angegebenen Merkmale gelöst.

Der mit der Erfindung erzielbare Vorteil liegt insbesondere darin, daß infolge der gegenseitigen Verkopplung der beiden Logikblöcke keine Querströme zwischen Versorgungsspannung VDD und Bezugspotential VSS auftreten können und damit eine wesentlich geringere Verlustleistung erreicht wird.

Die Patentansprüch 2 bis 4 sind auf bevorzugte Ausgestaltungen der erfindungsgemäßen Logikschaltung gerichtet.

Die Erfindung wird nachfolgend anhand der Zeichnung näher erläutert. Dabei zeigt
- Figur 1: eine bereits bekannte Logikschaltung für asynchrone Schaltungen,
- Figur 2: eine erfindungsgemäße Logikschaltung für asynchrone Schaltungen,
- Figur 3: ein Ausführungsbeispiel eines ersten Logikblocks einer bekannten oder erfindungsgemäßen Logikschaltung,
- Figur 4: ein zum ersten Logikblock aus Figur 3 passender zweiter Logikblock bei einer bekannten Logikschaltung und
- Figur 5: ein zum ersten Logikblock aus Figur 3 passender zweiter Logikblock bei einer erfindungsgemäßen Logikschaltung.

Asynchrone oder "self-timed" Schaltungen werden als zukunftsträchtiges Schaltungsprinzip für den sub-µm-Bereich angesehen, da bei der derzeitigen üblichen globalen Taktansteuerung in zukünftigen hochkomplexen und äußerst schnellen Schaltungen Laufzeitprobleme (clock skew) in der Taktversorgung auftreten, die ein entsprechendes System in seinen Abmessungen begrenzen und/oder zu einer reduzierten Verarbeitungsgeschwindigkeit führen. Bei asynchronen Schaltungen, die nach einem "hand shake"-Verfahren miteinander kommunizieren, sind diese durch einen zentralen Takt bedingten Probleme ausgeschlossen.

Als Basis für solche asynchronen Schaltungen werden Logikschaltungen benötigt, die auf ein Anfragesignal (request) hin eine logische Verknüpfung durchführen und sobald gültige Daten am Ausgang der Logikschaltung anliegen ein Fertigmeldungs-Signal (completion) an einem entsprechenden Ausgang der Logikschaltung zur Verfügung stellen.

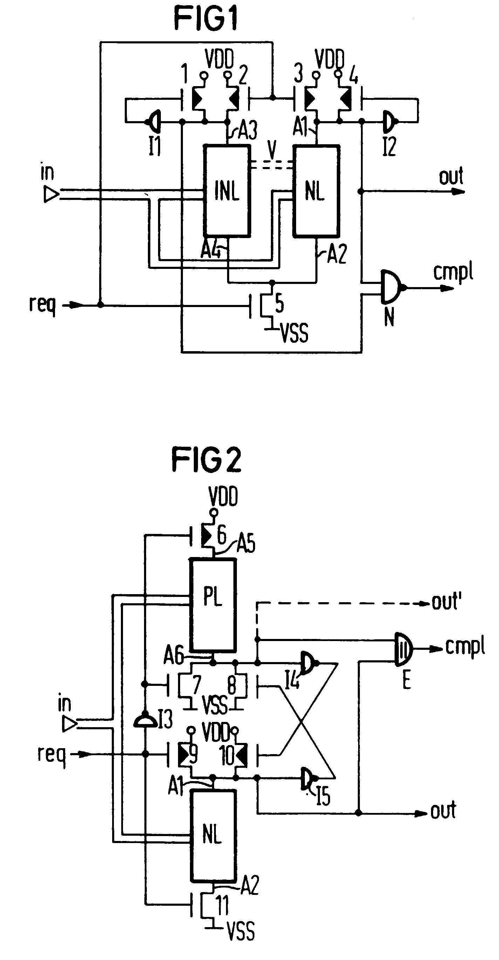

Eine Logikschaltung für asynchrone Schaltungen ist in der Regel gemäß Figur 1 aufgebaut und wird als differential cascode voltage switched logik (DCVSL) bezeichnet. Bei der in Figur 1 gezeigten Logikschaltung ist eine Mehrzahl von Eingangsleitungen (in) sowohl mit einem ersten Logikblock (NL) als auch mit einem zweiten Logikblock (INL) verbunden, wobei der zweite Logikblock INL invers zum ersten Logikblock NL ist. Ein Ausgang A1 des Logikblocks NL ist jeweils mit einem Anschluß eines Transistors 3 und eines Transistors 4 eines ersten Vorlade-Transistorpaares und ein Ausgang A2 des ersten Logikblocks NL ist mit einem Anschluß eines Ladetransistors 5 verbunden. Ein Ausgang A3 des zweiten Logikblocks NL ist jeweils mit einem Anschluß eines Transistors 1 und eines Transistors 2 eines zweiten Vorlade-Transistorpaares und ein Ausgang A4 des zweiten Logikblocks INL ist, aus Ersparnisgründen, ebenfalls mit dem Ladetransistor 5 verbunden. Ein Gate des Transistors 3 des ersten Vorlade-Transistorpaares und ein Gate des Transistors 2 des zweiten Vorlade-Transistorpaares ist direkt mit einem Anfrage-Eingang req verbunden. Ein Gate des Transistors 4 des ersten Vorlade-Transistorpaares ist mit einem Ausgang eines Rückkoppel-Inverters I2 und ein Gate des Transistors 1 des zweiten Vorlade-Transistorpaares ist mit einem Ausgang eines Rückkoppel-Inverters I1 verbunden. Der Ausgang A1 des ersten Logikblocks NL ist mit einem ersten Eingang einer NAND-Verknüpfung N und der Ausgang A3 des zweiten Logikblocks INL ist mit einem zweiten Eingang der logischen Verknüpfung N verbunden und ein Ausgang der NAND-Verknüpfung stellt einen Fertigmeldungs-Ausgang cmpl dar. Ein zweiter Anschluß der Transistoren 1 ... 4 des ersten und zweiten Vorlade-Transistorpaares ist jeweils mit einer Versorgungsspannung VDD und ein zweiter Anschluß des Ladetransistors 5 ist mit Bezugspotential verbunden. Der erste Logikblock NL und der Ladetransistor 5 bestehen dabei aus Transistoren eines ersten Kanaltyps, beispielsweise aus n-Kanal-Transistoren, und die beiden Vorlade-Transistorpaare besitzen Transistoren eines zweiten Kanaltyps, beispielsweise p-Kanal-Transistoren. Ein Ausgang out ist entweder mit dem ersten Ausgang A1 des ersten Logikblocks NL oder mit dem ersten Ausgang A3 des zweiten Logikblocks INL verbunden. Teile der Logikblöcke NL und INL sind gegebenenfalls gegenseitig nutzbar, dies ist durch eine gestrichelt gezeichnete Verbindung V zwischen den beiden Logikblöcken angedeutet.

Liegt bei der bekannten, gemäß Figur 1 ausgebildeten Logikschaltung ein Low-Pegel am Anfrage-Eingang req, so befindet sich die Logikschaltung im Vorladestadium und die Transistoren 2 und 3 des ersten und zweiten Vorlade-Transistorpaares sind leitend und der Ladetransistor 5 sperrt, wodurch die beiden Ausgänge A1 und A3 der beiden Logikblöcke NL und INL dabei jeweils High-Pegel und der Fertigmeldungs-Ausgang cmpl Low-Pegel erhalten. Damit die beiden Ausgänge A1 und A2 nach einer Pegeländerung am Anfrage-Eingang req nur durch die beiden Logikblöcke beeinflußbar sind, werden die Pegel der Ausgänge A1 und A3 der Logikblöcke auf die Gates der zweiten Transistoren 1 bzw. 4 des jeweiligen Vorlade-Transistorpaares über die Inverter I1 bzw. I2 rückgekoppelt. Erhält nun der Anfrage-Eingang req High-Potential so sperren die beiden Transistoren 2 und 3 der beiden Vorlade-Transistorpaare und die beiden Transistoren 1 und 4 der Vorlage-Transistorpaare leiten weiterhin. Da immer entweder der Ausgang A1 des ersten Logikblocks oder der Ausgang A3 des zweiten Logikblocks auf Low-pegel entladen werden muß, ist ein Signal am Ausgang out der Logikschaltung dann gültig, wenn eine Umladung einer der beiden Ausgänge A1 oder A3 erfolgt ist. Genaugenommen liegen gültige Daten am Ausgang out der Logikschaltung um die Laufzeit der NAND-Verknüpfung N früher an als dies das Fertigmeldungs-Signal cmpl anzeigt. Da, aufgrund der Rückkoppel-Inverter I1 und I2, die Transistoren 1 und 4 solange leitend sind bis gültige Daten am Ausgang der Logikschaltung vorliegen, können Querströme fließen, da die Transistoren eines Logikblocks und der Ladetransistor 5 gleichzeitig leitend sind.

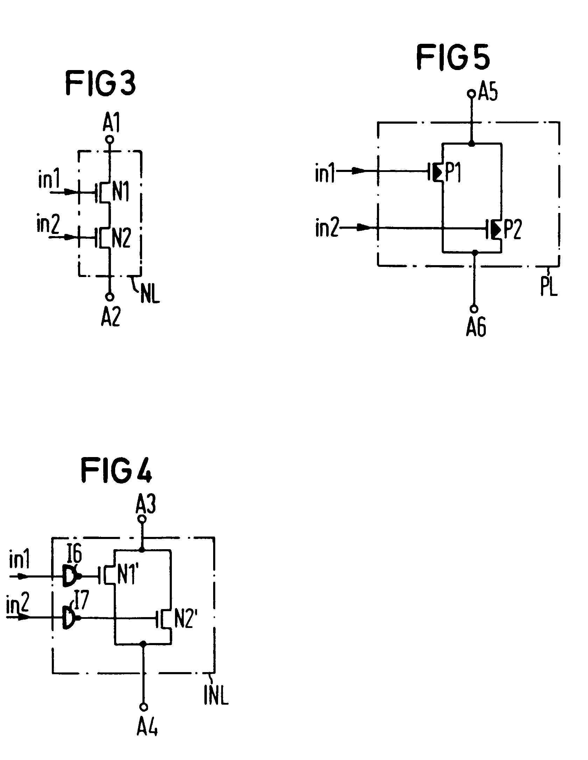

Besteht der erste Logikblock beispielsweise, wie in Figur 3 gezeigt, aus zwei in Reihe geschalteten n-Kanal-Transistoren N1 und N2, deren Gates direkt mit Eingängen inl bzw. in2 der Logikschaltung verbunden sind, so stellt der erste Logikblock NL eine UND-Verknüpfung dar, die aufgrund der Gesamtschaltung am Ausgang out der Logikschaltung eine NAND-Verknüpfung realisiert. Die zum ersten Logikblock inverse NAND-Schaltung des zweiten Logikblocks ist, wie in Figur 4 dargestellt, in n-Kanal-Technik als ODER-Verknüpfung mit invertierten Eingängen realisierbar. Die beiden Transistoren N1' und N2' sind dabei parallelgeschaltet und ihre Gates sind jeweils über Inverter 16 und 17 mit Eingängen in1 bzw. in2 der Logikschaltung verbunden.

In Figur 2 ist eine erfindungsgemäße Logikschaltung für asynchrone Schaltungen gezeigt, bei der nur ein erster Logikblock NL aus n-Kanal-Transistoren und ein zweiter Logikblock PL aus p-Kanal-Transistoren besteht. Sowohl der erste Logikblock als auch der zweite Logikblock sind wie in der Logikschaltung von Figur 1 mit Eingängen in der Logikschaltung verbunden. Der erste Logikblock NL ist an einem Ausgang A1 sowohl über einen Transistor 9 als auch über einen Transistor 10 eines ersten Vorlade-Transistorpaares mit der Versorgungsspannung VDD und an einem Ausgang A2 über einen Ladetransistor 11 mit Bezugspotential VSS verbunden. In entsprechender Weise ist der zweite Logikblock PL an einem Ausgang A6 über einen Transistor 7 und einen Transistor 8 eines Vorlade-Transistorpaares mit Bezugspotential VSS und an einem Ausgang A5 über einen Ladetransistor 6 mit der Versorgungsspannung VDD verbunden. Hierbei sind die Transistoren 6, 9 und 10 p-Kanal-Transistoren und die Transistoren 7, 8 und 11 n-Kanal-Transistoren. Ein Anfrage-Eingang req der Logikschaltung ist direkt mit einem Gate des Transistors 9 des ersten Vorlade-Transistorpaares und einem Gate des Ladetransistors 11 sowie indirekt über einen Inverter I3 mit einem Gate des Transistors 7 eines zweiten Vorlade-Transistorpaares und einem Gate des Ladetransistors 6 verbunden. Der Ausgang A1 des ersten Logikblocks NL ist über einen Inverter I5 mit einem Gate des Transistors 8 des zweiten Vorlade-Transistorpaares und der Ausgang A6 ist über einen Inverter I4 mit einem Gate des Transistors 10 des ersten Vorlade-Transistorpaares verbunden. Eine Äquivalenzverknüpfung E ist eingangsseitig mit dem Ausgang A1 des Logikblocks NL und dem Ausgang A6 des Logikblocks PL sowie ausgangsseitig mit einem Fertigmeldungs-Ausgang cmpl der Logikschaltung verbunden. Der Ausgang A1 des Logikblocks NL kann als Ausgang out der Logikschaltung und/oder der Ausgang A6 des Logikblocks PL kann, wie in Figur gestrichelt angedeutet, als Ausgang out' der Logikschaltung herausgeführt sein.

Liegt am Anfrage-Eingang req der Logikschaltung Low-Potential, so sind beide Ladetransistoren 6 und 11 gesperrt und die beiden Transistoren 7 und 9 der beiden Vorlade-Transistorpaare sind leitend. Der Ausgang A1 des Logikblocks NL und der Ausgang out der Logikschaltung sowie ein Eingang der Äquivalenzverknüpfung E erhalten High-Pegel, wohingegen der Ausgang A6 des Logikblocks PL und der zweite Eingang der Äquivalenzverknüpfung E Low-Pegel erhalten und somit der Fertigmeldungs-Ausgang cmpl der Logikschaltung Low-Pegel annimmt, da keine Äquivalenz vorliegt. Die beiden Transistoren 8 und 10 der beiden Vorlade-Transistorpaare sind jeweils gegenseitig gesperrt. Wird nun am Anfrage-Eingang req der Logikschaltung High-Potential angelegt, so werden die Transistoren 7 und 9 der beiden Vorlade-Transistorpaare gesperrt und die beiden Ladetransistoren 8 und 10, bleiben durch die gegenseitige Verkoppelung über die Inverter I4 und I5, gesperrt, wodurch ein Auftreten von Querströmen vermieden wird. Da die beiden Logikblöcke zueinander invers sind, wird einer der beiden Ausgänge A1 und A6 seinen Vorladepegel beihalten und der andere Ausgang seinen Vorladepegel ändern. Dabei wird er über den mit ihm verbundenen Inverter I4 bzw. I5 und dem Transistor 10 bzw. 8 auf dem Vorladepegel des jeweils anderen Ausgang statisch festgehalten. Ist die Änderung des Vorladepegels an einem Ausgang abgeschlossen, so haben beide Ausgänge A1 und A6 den gleichen Pegel und am Fertigmeldungsausgang cmpl der Logikschaltung zeigt High-Potential gültige Daten am Ausgang out der Logikschaltung an.

Wird wieder, wie eingangs beschrieben, für den Logikblock NL die in Figur 3 gezeigte UND-Schaltung aus den beiden Transistoren N1 und N2 verwendet, so ist eine, in Figur 5 dargestellte, ODER-Schaltung aus einer Parallelschaltung von zwei p-Kanal-Transistoren P1 und P2 für den Logikblock PL zu wählen. Die Parallelschaltung der beiden p-Kanal-Transistoren P1 und P2 liegt zwischen den Ausgängen A5 und A6 und das Gate des Transistors P1 ist mit einem Eingang inl der Logikschaltung und das Gate des Transistors P2 ist mit einem Eingang in2 der Logikschaltung verbunden. Wie dies auch aus dem Beispiel von Figur 4 und Figur 5 deutlich wird, können bei der erfindungsgemäßen Logikschaltung, im Gegensatz zur bekannten Logikschaltung, eine Reihe von Invertern, beispielsweise I6 und I7, eingespart werden und dadurch der geringe Mehraufwand eines Äquivalenzgatters E, besonders bei größeren Logikblöcken, oft mehr als ausgeglichen werden. Ein gegenseitiges Ausnützen von Teilen der beiden Logikblöcke NL und PL, wie dies bei Figur 1 durch die Verbindung V zum Ausdruck kommt, ist ebenfalls denkbar.

## Patentansprüche

1. Logikschaltung mit differentieller Kaskode-Spannungslogik bei der eine Vielzahl von Eingangsleitungen (in) sowohl mit einem ersten Logikblock (NL) als auch mit einem zweiten Logikblock (PL) verbunden sind, deren Schaltverhalten zweinander komplementär ist, bei der, abhängig von Signalen auf den Eingangsleitungen, entweder ein erster Ausgang (A1) des ersten Logikblocks (NL) auf einen zweiten Ausgang (A2) des ersten Logikblocks durchgeschaltet und dabei ein erster Ausgang (A6) des zweiten Logikblocks (PL) von einem zweiten Ausgang (A5) des zweiten Logikblocks getrennt ist oder der erste Ausgang des ersten Logikblocks vom zweiten Ausgang des ersten Logikblocks getrennt und dabei der erste Ausgang des zweiten Logikblocks auf den zweiten Ausgang des zweiten Logikblocks durchgeschaltet ist,
bei der der erste Ausgang (A1) des ersten Logikblocks (NL) jeweils mit einem ersten Anschluß eines ersten (9) und zweiten Transistors (10) eines ersten Vorlade-Transistorpaares und der zweite Ausgang (A2) des ersten Logikblocks (NL) mit einem ersten Anschluß eines ersten Ladetransistors (11) verbunden ist,
bei der der erste Ausgang (A6) des zweiten Logikblocks (PL) jeweils mit einem ersten Anschluß eines ersten (7) und zweiten Transistors (8) eines zweiten Vorlade-Transistorpaares und der zweite Ausgang (A5) des zweiten Logikblocks (PL) mit einem ersten Anschluß eines zweiten Ladetransistors (6) verbunden ist,
bei der ein Gate des ersten Transistors (9) des ersten Vorlade-Transistorpaares und ein Gate des mit dem ersten Logikblock verbundenen Ladetransistors (11) direkt mit einem Anfrage-Eingang (req) verbunden ist,
bei der bei einem ersten logischen Pegel am Anfrage-Eingang nur die Transistoren der Vorlade-Transistorpaare (7,8,9,10) leiten und alle vorhandenen Ladetransistoren (6, 11) sperren und beim zweiten logischen Pegel am Anfrage-Eingang nur alle vorhandenen Ladetransistoren leiten und die Transistoren der Vorlade-Transistorpaare sperren,
bei der ein Gate des zweiten Transistors (10) des ersten Vorlade-Transistorpaares mit einem Ausgang eines ersten Rückkoppel-Inverters (I4) verbunden ist,
bei der ein Gate des zweiten Transistor (8) des zweiten Vorlade-Transistorpaares mit einem Ausgang eines zweiten Rückkoppel-Inverters (I5) verbunden ist,
bei der der erste Ausgang (A1) des ersten Logikblocks mit einem ersten Eingang einer Äquivalenz-Verknüpfung (E) und der erste Ausgang des zweiten Logikblocks (A6) mit einem zweiten Eingang der Äquivalenz-Verknüpfung (E) verbunden sind und ein Ausgang der Äquivalenz-Verknüpfung einen Fertigmeldungs-Ausgang (cmpl) darstellt,
bei der jeweils ein zweiter Anschluß des ersten und zweiten Transistors des ersten Vorlade-Transistorpaares mit einer Versorgungsspannung (VDD) und ein zweiter Anschluß des mit dem ersten Logikblock verbundenen Ladetransistors (11) auf Bezugspotential (VSS) gelegt ist,
bei der der erste Logikblock (NL) aus Transistoren eines ersten Kanaltyps besteht, der mit dem ersten Logikblock verbundene Ladungstransistor (11) ebenfalls einen ersten Kanaltyp besitzt und sowohl der erste (9) als auch der zweite Transistor (10) des ersten Vorlade-Transistorpaares einen zweiten Kanaltyp besitzen und
bei der der zweite Logikblock aus Transistoren besteht, deren Kanaltyp mit dem Kanaltyp des mit dem zweiten Logikblock verbundenen Ladetransistors (6) übereinstimmt und sich sowohl vom Kanaltyp des ersten (7) als auch des zweiten Transistors (8) des zweiten Vorlade-Transistorpaares unterscheidet,
**dadurch gekennzeichnet**,
daß ein Eingang des ersten Rückkoppel-Inverters (I4) mit dem ersten Ausgang (A6) des zweiten Logikblocks (PL) verbunden ist,
daß ein Eingang des zweiten Rückkoppel-Inverters (I5) mit dem ersten Ausgang (A1) des ersten Logikblocks (NL) verbunden ist,
daß ein Gate des mit dem zweiten Logikblock (PL) verbundenen Ladetransistors (6) und ein Gate des ersten Transistors (7) des zweiten Vorlade-Transistorpaares über einen Inverter (I3) mit dem Anfrage-Eingang (req) verbunden sind,
daß der zweite Logikblock (PL) einen, zum ersten Kanaltyp des ersten Logikteils (NL) verschiedenen, zweiten Kanaltyp besitzt, und
daß ein zweiter Anschluß des mit dem zweiten Logikblock verbundene Ladetransistors (6) mit der Versorgungsspannung (VDD) und jeweils ein zweiter Anschluß des ersten und zweiten Vorladetransistors (7, 8) des zweiten Vorlade-Transistorpaares mit Bezugspotential (VSS) verbunden sind.

2. Logikschaltung nach Anspruch 1, **dadurch gekennzeichnet**, daß ein Ausgang (out) der Logikschaltung mit dem ersten Ausgang (A1) des ersten Logikblocks (NL) verbunden ist.

3. Logikschaltung nach Anspruch 1 oder 2, **dadurch gekennzeichnet**, daß ein Ausgang (out') der Logikschaltung mit dem ersten Ausgang (A6) des zweiten Logikblocks (PL) verbunden ist.

4. Logikschaltung nach einem der Ansprüche 1 bis 3, **dadurch gekennzeichnet**, daß der erste Logikblock (NL) n-Kanal-Transistoren und der zweite Logikblock (PL) aus p-Kanal-Transistoren aufgebaut ist.

## Claims

1. Logic circuit with differential cascode voltage logic in which a multiplicity of input lines (in) are connected both to a first logic block (NL) and also to a second logic block (PL), the switching behaviours of which are complementary to another,
in which, depending on signals on the input lines, either a first output (A1) of the first logic block (NL) is switched through to a second output (A2) of the first logic block and in this case a first output (A6) of the second logic block (PL) is disconnected from a second output (A5) of the second logic block, or the first output of the first logic block is disconnected from the second output of the first logic block and in this case the first output of the second logic block is switched through to the second output of the second logic block,
in which the first output (A1) of the first logic block (NL) is connected in each instance to a first connection of a first (9) and a second transistor (10) of a first pair of precharging transistors and the second output (A2) of the first logic block (NL) is connected to a first connection of a first charging transistor (11),
in which the first output (A6) of the second logic block (PL) is connected in each instance to a first connection of a first (7) and a second transistor (8) of a second pair of precharging transistors, and the second output (A5) of the second logic block (PL) is connected to a first connection of a second charging transistor (6),
in which a gate of the first transistor (9) of the first pair of precharging transistors and a gate of the charging transistor (11) connected to the first logic block are directly connected to a request input (req),
in which, at a first logic level at the request input, only the transistors of the pairs of precharging transistors (7, 8, 9, 10) are switched on and all the charging transistors (6, 11) which are present are switched off and, at the second logic level at the request input, only all the charging transistors which are present are switched on and the transistors of the pairs of precharging transistors are switched off,
in which a gate of the second transistor (10) of the first pair of precharging transistors is connected to an output of a first feedback invertor (I4),
in which a gate of the second transistor (8) of the second pair of precharging transistors is connected to an output of a second feedback invertor (I5),
in which the first output (A1) of the first logic block is connected to a first input of an exclusive-NOR gate (E) and the first output of the second logic block (A6) is connected to a second input of the exclusive-NOR gate (E), and an output of the exclusive-NOR gate represents a complete message output (cmpl),
in which in each instance a second connection of the first and second transistor of the first pair of precharging transistors has applied to it a supply voltage (VDD) and a second connection of the charging transistor (11) connected to the first logic block is set to reference-earth potential (VSS),
in which the first logic block (NL) comprises transistors of a first channel type, the charging transistor (11) connected to the first logic block also possesses a first channel type and both the first (9) and also the second transistor (10) of the first pair of precharging transistors possess a second channel type and,
in which the second logic block comprises transistors, the channel type of which corresponds to the channel type of the charging transistor (6) connected to the second logic block and differs both from the channel type of the first (7) and also of the second transistor (8) of the second pair of precharging transistors,
characterized in that
an output of the first feedback invertor (I4) is connected to the first output (A6) of the second logic block (PL),
in that an input of the second feedback invertor (I5) is connected to the first output (A1) of the first logic block (NL),
in that a gate of the charging transistor (6) connected to the second logic block (PL) and a gate of the first transistor (7) of the second pair of precharging transistors are connected via an invertor (I3) to the request input (req),
in that the second logic block (PL) is of a second channel type different from the first channel type of the first logic section (NL),
and in that a second connection of the charging transistor (6) connected to the second logic block is connected to the supply voltage (VDD) and in each instance a second connection of the first and second precharging transistor (7, 8) of the second pair of precharging transistors are connected to reference-earth potential (VSS).

2. Logic circuit according to Claim 1, characterized in that an output (out) of the logic circuit is connected to the first output (A1) of the first logic block (NL).

3. Logic circuit according to Claim 1 or 2, characterized in that an output (out') of the logic circuit is connected to the first output (A6) of the second logic block (PL).

4. Logic circuit according to one of Claims 1 to 3, characterized in that the first logic block (NL) is formed from n-channel transistors and the second logic block (PL) is formed from p-channel transistors.

## Revendications

1. Circuit logique avec logique à tension cascode différentielle, dans lequel une pluralité de lignes d'entrée (in) est reliée tant à un premier bloc logique (NL) qu'à un second bloc logique (PL) dont le comportement logique est mutuellement complémentaire,
dans lequel, selon des signaux présents sur les lignes d'entrée, soit une première sortie (A1) du premier bloc logique (NL) est interconnectée avec une seconde sortie (A2) du premier bloc logique et par la-même une première sortie (A6) du second bloc logique (PL) est séparée d'une seconde sortie (A5) du second bloc logique soit la première sortie du premier bloc logique est séparée de la seconde sortie du premier bloc logique et par la-même la première sortie du second bloc logique est interconnectée avec la seconde sortie du premier bloc logique,
dans lequel la première sortie (A1) du premier bloc logique (NL) est reliée respectivement à une première connexion d'un premier (9) et d'un second transistor (10) d'une première paire de transistors préchargeurs et la seconde sortie (A2) du premier bloc logique (NL) est reliée à une première connexion d'un premier transistor chargeur (11),
dans lequel la première sortie (A6) du second bloc logique (PL) est reliée respectivement à une première connexion d'un premier (7) et d'un second (8) transistor d'une seconde paire de transistors préchargeurs et la deuxième sortie (A5) du second bloc logique (PL) est reliée à une première connexion d'un second transistor chargeur (6),
dans lequel une porte du premier transistor (9) de la première paire de transistors chargeurs et une porte du premier transistor chargeur (11) reliée au premier bloc logique est reliée directement à une entrée de demande (req),
dans lequel à un premier niveau logique à l'entrée de demande seuls les transistors des paires de transistors préchargeurs (7, 8, 9, 10) sont conducteurs et tous les transistors chargeurs présents (6, 11) bloquent et à un second niveau logique à l'entrée de demande seuls tous les transistors chargeurs présents sont conducteurs et les transistors des paires de transistors préchargeurs bloquent,
dans lequel une porte du second transistor (10) de la première paire de transistors préchargeurs est reliée à une sortie d'un premier inverseur de réaction (I4),
dans lequel une porte du second transistor (8) de la deuxième paire de transistors préchargeurs est reliée à une sortie d'un second inverseur de réaction (I5),
dans lequel la première sortie (A1) du premier bloc logique est reliée à une première entrée d'une liaison d'équivalence (E) et la première sortie du second bloc logique (A6) est reliée à une seconde entrée de la liaison d'équivalence (E) et une sortie de la liaison d'équivalence constitue une sortie d'achèvement de la liaison (cmpl),
dans lequel une seconde connexion respectivement du premier et du second transistor de la première paire de transistors préchargeurs est reliée à une tension d'alimentation (VDD) et une seconde connexion du premier transistor chargeur (11) relié au premier bloc logique est placée sur potentiel de référence (VSS),
dans lequel le premier bloc logique (NL) est constitué de transistors d'un premier type de canal, le transistor chargeur (11) relié au premier bloc logique possède également un premier type de canal et aussi bien le premier (9) que le second transistor (10) de la première paire de transistors préchargeurs possède un second type de canal et
dans lequel le second bloc logique est constitué de transistors dont le type de canal coïncide avec le type de canal du transistor chargeur (6) relié au second bloc logique et qui se différencie à la fois du type de canal du premier transistor (7) et du deuxième transistor (8) de la seconde paire de transistors préchargeurs.,
**caractérisé en ce que**,
une entrée du premier inverseur de réaction (I4) est reliée à la première sortie (A6) du second bloc logique (PL), en ce qu'une entrée du second inverseur de réaction (15) est reliée à la première sortie (A1) du premier bloc logique (NL),
en ce qu'une porte du transistor de charge (6) reliée au second bloc logique (PL) et une porte du premier transistor (7) de la seconde paire de transistors préchargeurs est reliée à l'entrée de demande (req) via un inverseur (13), en ce que le second bloc logique (PL) possède un second type de canal différent du premier type de canal de la première partie logique (NL), et en ce qu'une seconde connexion du deuxième transistor chargeur (6) reliée au second bloc logique est reliée à la tension d'alimentation (VDD) et en ce qu'une seconde connexion du premier et du second transistor préchargeur (7, 8) de la seconde paire de transistors préchargeurs sont reliés respectivement à un potentiel de référence (VSS).

2. Circuit logique selon la revendication 1, **caractérisé en ce que** une sortie (out) du circuit logique est reliée à la première sortie (A1) du premier bloc logique (NL).

3. Circuit logique selon la revendication 1 ou 2, **caractérisé en ce que** une sortie (out') du circuit logique est reliée à la première sortie (A6) du second bloc logique (PL).

4. Circuit logique selon l'une des revendications 1 à 3, **caractérisé en ce que** le premier bloc logique (NL) est conçu à partir de transistors à canal n et le second bloc logique (PL) à partir de transistors à canal p.
